Europäisches Patentamt

European Patent Office

Office européen des brevets

(11) Veröffentlichungsnummer: **0 239 678 B1**

(12) # EUROPÄISCHE PATENTSCHRIFT

(45) Veröffentlichungstag der Patentschrift: **13.03.91**

(51) Int. Cl.⁵: **G01R 31/34, H02K 11/00**

(21) Anmeldenummer: **86117807.7**

(22) Anmeldetag: **19.12.86**

(54) **Verfahren und Vorrichtung zur Feststellung und Ortung von lokalen Übererwärmungen in flüssigkeits-gekühlten Wicklungen elektrischer Maschinen.**

(30) Priorität: **09.01.86 DE 3600421**

(43) Veröffentlichungstag der Anmeldung:
**07.10.87 Patentblatt 87/41**

(45) Bekanntmachung des Hinweises auf die Patenterteilung:
**13.03.91 Patentblatt 91/11**

(84) Benannte Vertragsstaaten:
**CH DE FR GB LI**

(56) Entgegenhaltungen:
**EP-A- 0 080 640**
**CH-A- 327 462**
**CH-A- 573 184**

(73) Patentinhaber: **Siemens Aktiengesellschaft**
**Wittelsbacherplatz 2**
**W-8000 München 2(DE)**

(72) Erfinder: **Wichmann, Arnold, Dr., Dipl.-Phys.**
**Eibenkamp 19**
**W-4330 Mülheim-Ruhr(DE)**
Erfinder: **Grünewald, Peter, Dipl.-Ing. (FH)**
**Berghausweg 19**
**W-4300 Essen(DE)**

Rank Xerox (UK) Business Services

## Beschreibung

Die vorliegende Erfindung betrifft ein Verfahren zur Feststellung von lokalen Übererwärmungen in flüssigkeitsgekühlten Wicklungen elektrischer Maschinen sowie eine Vorrichtung zur Durchführung des Verfahrens. Eine lokale Übererwärmung von kühlmittel-gekühlten Wicklungen kann insbesondere durch Verstopfung oder teilweise Verstopfung von Teilleitern der Wicklung hervorgerufen werden. Das Kühlmittel, in den meisten Fällen Wasser, kann dann die in diesem Bereich erzeugte Wärme nicht mehr abführen, wodurch dieser sich überhitzt, was zu schwerwiegenden Folgeschäden führen kann.

Bisher ist es üblich, in elektrischen Maschinen z. B. Nutenthermometer zur Kontrolle der Wicklungstemperatur anzubringen oder bei flüssigkeitsgekühlten Wicklungen Thermoelemente an den erdseitigen Enden der Kühlmittelanschlüsse der einzelnen Leiter anzubringen und die Temperaturen dort zu überwachen. Beide Verfahren sind relativ aufwendig und ihre Empfindlichkeit ist nicht besonders groß, da bei z. B. nur einem verstopften Teilleiter sich die lokale Temperaturänderung zunächst nach außen hin kaum bemerkbar macht.

Eine andere Überwachungsmethode besteht in der Verwendung eines sogenannten Generator Condition Monitors, der die entstehenden Gase und Partikel, die aus überhitzten Isolierstoffen stammen, anzeigt. Diese Anzeige erfolgt jedoch in der Regel zu spät, da der Schaden bis zum Ansprechen dieser Überwachungsmethode weit fortgeschritten sein muß. Auch ist bei dieser Methode eine sichere Ortung der Schadensstelle nicht möglich.

Aufgabe der vorliegenden Erfindung ist es, ein Verfahren anzugeben, welches eine schnelle Feststellung von lokalen Übererwärmungen in flüssigkeits-gekühlten Wicklungen ermöglicht und ggf. auch eine Ortung der Schadensstelle zuläßt. Ferner soll eine möglichst einfache Vorrichtung zur Durchführung des Verfahrens angegeben werden.

Zur Lösung dieser Aufgabe wird ein Verfahren nach dem Anspruch 1 vorgeschlagen. Die Erfindung geht dabei von der Erkenntnis aus, daß bei einer lokalen Übererwärmung die Kühlflüssigkeit, im allgemeinen Wasser, an der Schadensstelle bis zum Sieden aufgeheizt wird, wodurch Blasen entstehen, die sich an kühleren Stellen wieder auflösen. Diese Blasen verursachen charakteristische Geräusche, welche sich in der Flüssigkeit und ggf. auch in der den Kühlkreislauf bildenden Struktur fortpflanzen.

Erfindungsgemäß wird die Kühlflüssigkeit mittels einem oder mehreren Schallaufnehmern akustisch überwacht, wodurch im Schadensfalle die Blasengeräusche unmittelbar festgestellt werden können.

Gemäß Anspruch 2 bietet dieses Verfahren zusätzlich die Möglichkeit einer recht genauen Lokalisierung der Schadensstelle.

Da die Schallgeschwindigkeit im Kühlmittel im allgemeinen bekannt oder leicht meßbar ist, kann aus den Laufzeitdifferenzen, mit denen die Blasengeräusche bei den einzelnen Schallaufnehmern eintreffen, auf den Ort ihrer Entstehung zurückgerechnet werden. Eine eindeutige Lokalisierung ist schon mit drei Schallaufnehmern möglich. Da jeder Kühlkreislauf auch bei störungsfreiem Betrieb Geräusche erzeugt, welche die Überwachung stören können, wird gemäß Anspruch 3 weiterhin vorgeschlagen, diese Schallsignale auszufiltern und nur die typischen Frequenzen der Blasengeräusche zu überwachen und weiter zu verarbeiten. Es hat sich gezeigt, daß die Blasengeräusche sich besonders signifikant in einem Frequenzbereich unter 1 KHz, vorzugsweise bei ausgeprägten Oberwellenanteilen von ca. 300 Hz nachweisen lassen, da sie sich dort von dem übrigen Geräuschpegel deutlich abheben.

Gemäß Anspruch 4 können die Schallaufnehmer entweder direkt in der Kühlflüssigkeit angeordnet sein, oder es besteht die Möglichkeit, die Geräusche durch die Struktur des Kühlkreislaufes hindurch aufzunehmen. Im letzteren Falle muß ggf. zwischen den über die Struktur geleiteten Schallwellen und den durch die Flüssigkeit übertragenen Schallwellen unterschieden werden, was jedoch keine prinzipiellen Schwierigkeiten mit sich bringt.

Im Anspruch 5 ist eine Vorrichtung zur Durchführung des beschriebenen Verfahrens angegeben, mit vorteilhaften Ausgestaltungen in den Ansprüchen 6 bis 10, wie sie anhand der Zeichnung noch näher erläutert werden.

Ein Ausführungsbeispiel der Erfindung, nämlich eine Vorrichtung zur Überwachung der Ständerwicklungsstäbe eines Generators, ist in der Zeichnung beschrieben. Es zeigen

Fig. 1 eine Ansicht der Stirnseite einer wassergekühlten Ständerwicklung eines Generators in schematischer Darstellung,

Fig. 2 einen Längsschnitt entlang der Linie II-II in Fig.1,

Fig. 3 den schematischen Aufbau des elektronischen Meß- und Auswertungssystems und

Fig. 4 von einem Schreiber aufgezeichnete Schallsignale aus dem Kühlsystem einer Generatorwicklung.

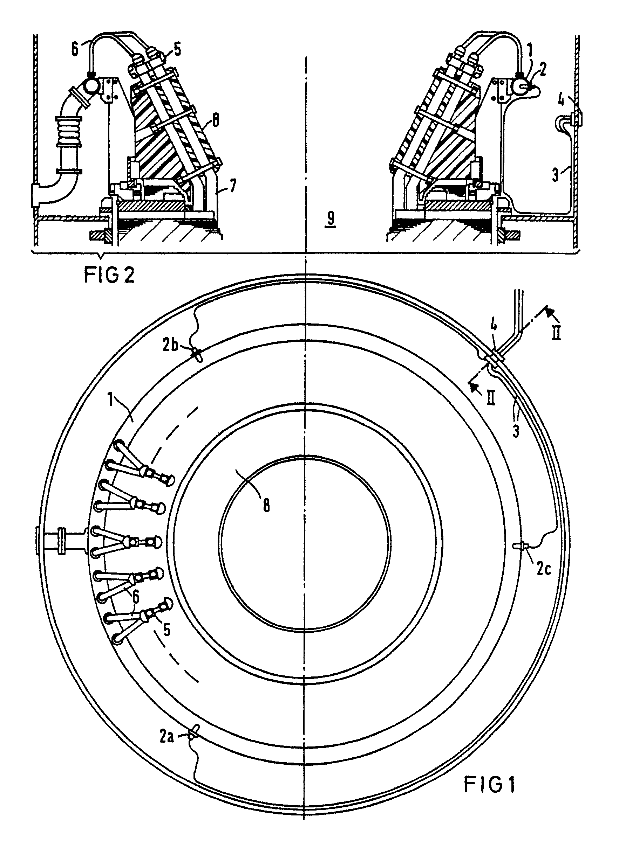

Fig. 1 zeigt in stark vereinfachter Darstellung eine Stirnansicht der Ständerwicklung eines Generators mit den zum Verständnis der Erfindung wichtigen Teilen. Fig. 2 zeigt den zugehörigen Längsschnitt entlang der Linie II-II in Fig. 1 durch diesen Stirnbereich des Generators. Die Ständerwicklungsstäbe 7 des Generatorständers sind von einem Kühlmittel, im vorliegenden Falle Wasser, durchströmbar. Dieses Kühlmittel gelangt aus einem ersten Wassersammelring 1 über Schlauchverbindungen 6 in die Ständerwicklungsstäbe 7 und nach dem Austritt aus den Ständerwicklungsstäben 7 wieder über Schlauchverbindungen 6 zu einem zweiten Wassersammelring 1, von wo es in den Kreislauf zurückgeführt wird. Die Enden der Ständerwicklungsstäbe 7 liegen zwischen Wickelkopfabdeckplatten 8 und weisen ggf. Schaltverbindungen 5 auf. Gemäß dem Ausführungsbeispiel der vorliegenden Erfindung ist einer der Wassersammelringe oder beide auf der Aus- und Eintrittsseite an mindestens zusammen drei Stellen, vorzugsweise jeweils mit gleichen Abständen untereinander, mit akustischen Schallaufnehmern 2a, 2b, 2c ausgestattet. Diese Schallaufnehmer sind z. B. als Hydrophone oder andere Schalldruckaufnehmer ausgebildet und mit der Flüssigkeit akustisch gekoppelt, so daß die sich in der Flüssigkeit fortpflanzenden Schallwellen in elektrische Signale umgewandelt werden können. Über elektrische Leitungen 3 werden diese Signale durch eine wasserstoffdichte Durchführung 4 zu einer Auswerteelektronik geleitet.

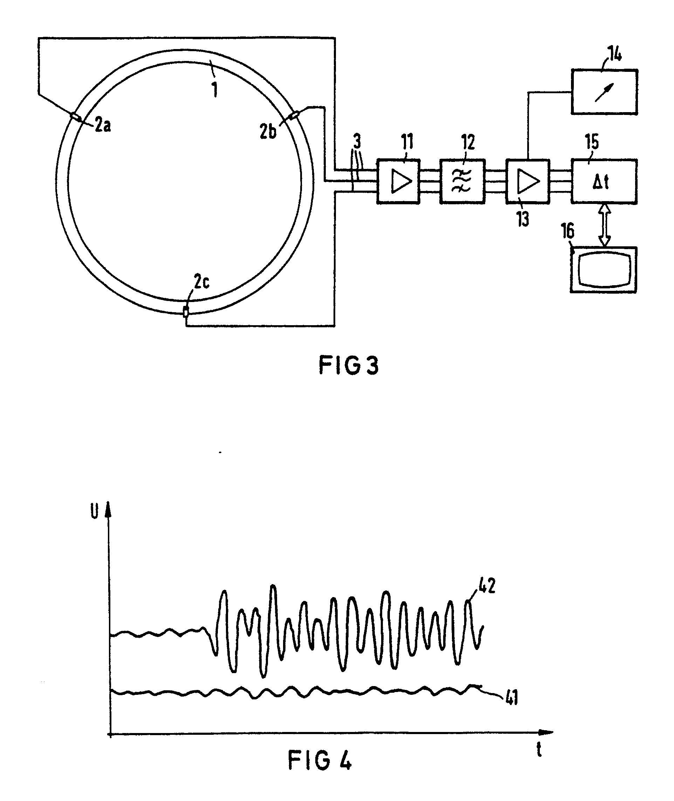

Die Weiterverarbeitung der elektrischen Signale in der Auswerteelektronik ist schematisch in Fig. 3 dargestellt. Jedes Signal jedes Schallaufnehmers 2a, 2b, 2c wird zunächst in einem Verstärker 11 verstärkt und anschließend in einem Bandpaßfilter 12 von störenden Untergrundgeräuschen befreit. Beim Auftreten von Blasengeräuschen, welche das Bandpaßfilter 12 passieren können, werden diese weiter verstärkt 13 und an eine Anzeige- oder Warneinrichtung 14, z. B. in einer Schaltwarte, weitergeleitet. Gleichzeitig können die Laufzeitdifferenzen $\Delta t$ zwischen den bei den einzelnen Schallaufnehmern registrierten Signalen in einem Analysegerät 15 ermittelt werden. Im einfachsten Falle arbeitet dieses Gerät wie eine Stoppuhr, d. h. es wird von dem ersten eintreffenden Blasengeräusch in Gang gesetzt und wieder gestoppt, wenn das Blasengeräusch von dem zweiten bzw. dritten Schallaufnehmer eintrifft. Für eine genauere Messung kann auch die zeitliche Korrelation zwischen den von den einzelnen Schallaufnehmern eintreffenden Signalen gebildet werden. Aus den sich ergebenden Laufzeitdifferenzen kann der defekte Wicklungsstab, aus dem die Geräusche stammen, sofort ermittelt werden. Er liegt immer in dem Sektor zwischen den beiden Schallaufnehmern, bei denen das Signal zuerst eingetroffen ist, wobei die Laufzeitdifferenz zwischen diesen beiden Aufnehmern und deren Vorzeichen in Verbindung mit der Schallgeschwindigkeit sofort eine genaue Lokalisierung zuläßt. Bei Einbeziehung der Laufzeitdifferenzen zu dem dritten Schallaufnehmer ist nicht einmal eine Kenntnis der Schallgeschwindigkeit nötig, da diese sich aus dem bekannten Abstand der Schallaufnehmer untereinander und der zusätzlich gemessenen Laufzeitdifferenz sofort ergibt. Die Information über den Schadensort kann dann beispielsweise über einen Monitor 16 ausgegeben werden.

Fig. 4 zeigt zur Veranschaulichung der Empfindlichkeit des Meßverfahrens von einem Schreiber aufgezeichnete Schallsignale aus dem Kühlsystem einer Generatorwicklung, aufgenommen mit einem Hydrophon am Wassersammelring. Aufgetragen ist die Signalspannung U gegen die Zeit t. Die untere (zur Veranschaulichung versetzt dargestellte) Kurve 41 zeigt den Null-Pegel der ungestörten Betriebsgeräusche im Frequenzband von etwa 200 Hz bis 300 Hz. Die obere Kurve 42 zeigt den Schallpegel beim Auftreten von Blasen im gleichen Frequenzband. Eine Unterscheidung der Blasengeräusche vom Null-Pegel in diesem Frequenzbereich ist dementsprechend sehr präzise und schnell möglich, wodurch die Überwachung sehr empfindlich wird.

## Ansprüche

1. Verfahren zur Feststellung von Übererwärmungen in flüssigkeitsgekühlten Wicklungen (7) elektrischer Maschinen, **dadurch gekennzeichnet,** daß die Kühlflüssigkeit mit einem oder mehreren Schallaufnehmer(n) (2a, 2b, 2c) akustisch überwacht wird, wodurch die Geräusche feststellbar sind, die durch bei lokaler Übererwärmung durch Überschreitung des Siedepunktes der Kühlflüssigkeit entstehende und sich wieder auflösende Blasen entstehen.

2. Verfahren nach Anspruch 1, **dadurch gekennzeichnet,** daß die akustische Überwachung mittels zweier oder mehrerer mit Abstand angeordneter Schallaufnehmer (2a, 2b, 2c) erfolgt und zusätzlich die Laufzeitdifferenzen eventueller Blasengeräusche gemessen werden, wodurch eine Ortung der Übererwärmungsstelle ermöglicht wird.

3. Verfahren nach Anspruch 1 oder 2, **dadurch gekennzeichnet,** daß durch frequenz-selektive Filter (12) die beim störungsfreien Betrieb der elektrischen Maschine entstehenden Schallsignale ausgefiltert und nur die typischen Frequenzen der Blasengeräusche weiterverarbeitet werden.

4. Verfahren nach Anspruch 1 , 2 oder 3, **dadurch gekennzeichnet,** daß die akustische Überwachung mittels in der Kühlfüssigkeit oder den Kühlmittelleitungen angeordneter Schallaufnehmer (2a, 2b, 2c) erfolgt.

5. Vorrichtung zur Feststellung von Übererwärmungen in flüssigkeits-gekühlten Wicklungen (7) elektrischer Maschinen gemäß einem der Ansprüche 1 bis 4, **dadurch gekennzeichnet,** daß an dem Kühlmittelkreislauf (1, 6, 7) der elektrischen Maschine ein oder mehrere Schallaufnehmer (2a, 2b, 2c) vorhanden ist (bzw. sind), welche(r) mit dem Kühlmittel bzw. dessen Leitungssystem akustisch gekoppelt ist (bzw. sind), wobei der (bzw. die) Schallaufnehmer mit einer Auswerteelektronik (11, 12, 13, 14, 15, 16) verbunden ist (bzw. sind), welche Blasengeräusche selektieren und anzeigen kann.

6. Vorrichtung nach Anspruch 5, **dadurch gekennzeichnet,** daß die Auswerteelektronik (11, 12, 13, 14, 15, 16) frequenz-selektive Filter (12) enthält, welche nur die typischen Frequenzen der Blasengeräusche durchlassen.

7. Vorrichtung nach Anspruch 6, **dadurch gekennzeichnet,** daß die frequenz-selektiven Filter Bandpaßfilter (12) sind, vorzugsweise für Frequenzen im Bereich der Blasengeräusche und deren Oberwellen, insbesondere im Frequenzbereich unter 1 kHz.

8. Vorrichtung nach Anspruch 5, 6 oder 7, **dadurch gekennzeichnet,** daß mindestens zwei, vorzugsweise drei Schallaufnehmer (2a, 2b, 2c) vorhanden sind und die Auswerteelektronik (11, 12, 13, 14, 15, 16) Mittel (15) zur Messung der Laufzeitdifferenzen zwischen an den Schallaufnehmern (2a, 2b, 2c) eintreffenden Blasengeräuschen aufweist.

9. Vorrichtung nach Anspruch 5, 6, 7 oder 8, **dadurch gekennzeichnet,** daß die Schallaufnehmer (2a, 2b, 2c) Hydrophone oder ähnliche Schalldruckaufnehmer sind.

10. Vorrichtung nach einem der Ansprüche 5 bis 9, **dadurch gekennzeichnet,** daß die flüssigkeits-gekühlte Wicklung die Ständerwicklung (7) eines Generators ist und daß die Schallaufnehmer (2a, 2b, 2c) an oder in dem (bzw. den) Kühlmittelsammelring(en) (1) angeordnet sind, vorzugsweise drei Schallaufnehmer (2a, 2b, 2c) mit gleichen Abständen untereinander in mindestens einem der Sammelringe.

## Claims

1. A method for determining overheating in liquid-cooled windings (7) of electric machines, characterised in that the cooling liquid is monitored acoustically with one or several sound receiver(s) (2a,2b,2c), whereby the noises are determined which occur through bubbles occurring and dissolving in the event of local overheating when exceeding the boiling point of the cooling liquid.

2. A method according to claim 1, characterised in that the acoustic monitoring occurs by means of two or several sound receivers (2a,2b,2c) arranged separated from one another and in addition the propagation time differences of possible bubble noises are measured, whereby a location of the overheating points is made possible.

3. A method according to claim 1 or 2, characterised in that by frequency-selective filters (12) the sound signals occurring with interference-free operation of the electric machine are filtered out and only the typical frequencies of the bubble noises are processed further.

4. A method according to claim 1,2 or 3, characterised in that the acoustic monitoring occurs by means of sound receivers (2a,2b,2c) arranged in the cooling liquid or the cooling agent lines.

5. A device for determining overheating in liquid-cooled windings (7) of electric machines according to one of claims 1 to 4, characterised in that on the cooling agent circuit (1,6,7) of the electric machine one or several sound receivers (2a,2b,2c) is (or are) present, which is (or are) coupled with the cooling agent or its circuit system acoustically, wherein the sound receiver (or receivers) is (or are) connected to an evaluating electronic system (11,12,13,14,15,16), which can indicate and select bubble noises.

6. A device according to claim 5, characterised in that the evaluating electronic system (11,12,13,14,15,16) contains frequency-selective filters (12), which only let through the typical frequencies of the bubble noises.

7. A device according to claim 6, characterised in that the frequency-selective filters are bandpass filters (12), preferably for frequencies in the region of the bubble noises and their harmonics, in particular in the frequency region below 1 kHz.

8. A device according to claim 5, 6 or 7, characterised in that at least two preferably three sound receivers (2a,2b,2c) are present and the evaluating electronic system (11,12,13,14,15,16) has means (15) for measuring the propagation time differences between bubble noises occurring at the sound receivers (2a,2b,2c).

9. A device according to claim 5,6,7 or 8, characterised in that the sound receivers (2a, 2b, 2c) are hydrophones or similar sound pressure receivers.

10. A device according to claims 5 to 9, characterised in that the liquid-cooled winding is the stator winding (7) of a generator and in that the sound receivers (2a,2b,2c) are arranged on or in the cooling agent collecting ring/s (1), preferably three sound receivers (2a,2b,2c) with the same separations in at least one of the collecting rings.

**Revendications**

1. Procédé pour déterminer des échauffements excessifs dans des enroulements (7), refroidis par un liquide, de machines électriques, caractérisé par le fait que l'on contrôle acoustiquement le fluide de refroidissement à l'aide d'un ou plusieurs capteurs acoustiques (2a,2b,2c), qui permettent de déterminer les bruits produits par suite de la formation de bulles qui apparaissent sous l'effet d'un échauffement local excessif par dépassement du point d'ébullition du liquide de refroidissement et se désintègrent à nouveau.

2. Procédé suivant la revendication 1, caractérisé par le fait que le contrôle acoustique est réalisé à l'aide de deux ou de plusieurs capteurs acoustiques (2a,2b,2c) distants les uns des autres et qu'on mesure en outre les différences des temps de propagation d'éventuels bruits produits par les bulles, ce qui permet une localisation du point d'échauffement excessif.

3. Procédé suivant la revendication 1 ou 2, caractérisé par le fait que les signaux acoustiques apparaissant lors du fonctionnement non perturbé de la machine électrique sont séparés par filtrage au moyen d'un filtre (12) sélectif du point des fréquences et que seules les fréquences typiques produites par les bulles sont traitées ultérieurement.

4. Procédé suivant la revendication 1, 2 ou 3, caractérisé par le fait que le contrôle acoustique est réalisé à l'aide de capteurs acoustiques (2a,2b,2c) disposés dans le liquide de refroidissement ou dans les conduites véhiculant ce liquide.

5. Dispositif pour déterminer des échauffements excessifs dans des enroulements (7), refroidis par un liquide, de machines électriques suivant l'une des revendications 1 à 4, caractérisé par le fait que dans le circuit (1,6,7) du fluide de refroidissement de la machine électrique sont prévus un ou plusieurs capteurs acoustiques (2a,2b,2c) couplés acoustiquement au liquide de refroidissement ou au système de canalisation le véhiculant, le ou les capteurs acoustiques étant reliés à un système électronique d'évaluation (11,12, 13,14,15,16), qui peut sélectionner et indiquer des bruits produits par des bulles.

6. Dispositif suivant la revendication 5, caractérisé par le fait que le système électronique d'évaluation (11,12,l3,14,15,16) contient des filtres (12) sélectifs du point de vue de la fréquence, qui transmettent uniquement les fréquences typiques des bruits produits par les bulles.

7. Dispositif suivant la revendication 6, caractérisé par le fait que les filtres sélectifs du point de vue de la fréquence sont des filtres passebande (12), prévus de préférence pour des fréquences situées dans la gamme des bruits produits par les bulles et pour leurs harmoniques, situés notamment dans la gamme de fréquences inférieures à 1 kHz.

8. Dispositif suivant la revendication 4,5 ou 7, caractérisé par le fait qu'il est prévu au moins deux et de préférence trois capteurs acoustiques (2a,2b,2c), et que le système électronique d'évaluation (11,12,13,14,15,16) comporte des moyens (15) pour mesurer les différences de temps de propagation entre les bruits produits par les bulles, qui atteignent les capteurs acoustiques (2a,2b,2c).

9. Dispositif suivant la revendication 5,6,7 ou 8, caractérisé par le fait que les capteurs acoustiques (2a,2b, 2c) sont des hydrophones ou des capteurs semblables de pression acoustique.

10. Dispositif suivant l'une des revendications 5 à 9, caractérisé par le fait que l'enroulement, refroidi par un liquide, est l'enroulement statorique (7) d'un générateur et que les capteurs acoustiques (2a,2b,2c) sont disposés sur ou dans le ou les anneaux (1) de collecte du fluide de refroidissement, de préférence trois capteurs acoustiques (2a,2b, 2c) qui sont équidistants dans au moins l'un des anneaux de collecte.

FIG 2

FIG 1

FIG 3

FIG 4